# EUROPEAN PATENT APPLICATION

(11) **EP 4 647 781 A1**
(43) Date of publication of application: **12.11.2025**
(21) Application number: 24883553.0
(22) Date of filing: 16.04.2024
(51) Int. Cl.: G01R 31/00, G06F 1/26

(54) **PHOTOVOLTAIC ENERGY STORAGE INVERTER AGING SYSTEM MODULE TESTING APPARATUS AND TESTING METHOD THEREOF**

(30) Priority: 12.03.2024 CN 202410281827
(71) Applicant: Sineng Electric Co., Ltd., Wuxi, Jiangsu 214174 (CN); Suzhou Qiancheng New Energy Technology Co., Ltd., Suzhou, Jiangsu 215101 (CN)
(72) Inventor: REN, Taoyi, Wuxi, Jiangsu 214174 (CN); LIU, Baodong, Wuxi, Jiangsu 214174 (CN); LIAO, Xiwen, Wuxi, Jiangsu 214174 (CN); GU, Yueming, Wuxi, Jiangsu 214174 (CN); XIAO, Liujie, Wuxi, Jiangsu 214174 (CN)
(74) Representative: Bayramoglu et al.
(86) International application number: PCT/CN2024/088011
(87) International publication number: WO 2025/189525

(57) **Abstract**

This application is applicable to the field of photovoltaic inverter test technologies, and provides an apparatus for testing an aging system module of a photovoltaic energy storage inverter and a test method therefor. The apparatus includes at least one direct current power supply, a plurality of contactors, and an energy storage inverter. The energy storage inverter includes at least one boost module, a DC/DC module, and an inverter module. A PV end of each boost module is connected to an end of each direct current power supply, the other end of each boost module is connected to one end of the inverter module, a BAT end of the DC/DC module is connected in series to one contactor and is connected in parallel to at least one boost module, a GRID end and an EPS end of the other end of the inverter module are connected in series to different contactors respectively and are connected to one end of an alternating current power supply, and the other end of the alternating current power supply is connected to each direct current power supply. In this application, an internal signal cycle is performed between the boost module and the DC/DC module to simulate battery charge/discharge, without a need for a bidirectional analog source. This can reduce costs. In addition, there is no need for a plurality of parallel machines for testing and an external load. This can reduce energy consumption.

## Description

This application claims priority to Chinese Patent Application No. 202410281827.8, filed with the China National Intellectual Property Administration on March 12, 2024, and entitled "APPARATUS FOR TESTING AGING SYSTEM MODULE OF PHOTOVOLTAIC ENERGY STORAGE INVERTER AND TEST METHOD THEREFOR", which is incorporated herein by reference in its entirety.

### TECHNICAL FIELD

This application relates to the field of photovoltaic inverter test technologies, and in particular, to an apparatus for testing an aging system module of a photovoltaic energy storage inverter and a test method therefor.

### BACKGROUND

Based on a conventional aging mode, in an energy storage inverter, a BAT end needs to be charged and discharged by using a bidirectional analog source, a PV end needs to be powered by a direct current power supply, and an EPS end needs to be connected to an analog load or a real load. In the conventional technology, aging is performed in a two-machine parallel manner. BAT ports of two inverters are connected, a BAT end of one inverter is discharged, and a BAT end of the other inverter is charged, so as to implement an energy cycle between BATs of the two machines without a need for a separate bidirectional analog source. Alternatively, one inverter is used as a master, and a plurality of inverters are used as slaves, so as to achieve a multi-split effect.

However, in the foregoing manner, a bidirectional analog source needs to be used at the BAT end, which has a high price, and a load is required at the EPS end, which causes high loss and is not conducive to energy saving. In the two-machine parallel manner, two inverters need to be aged at the same time, which causes mutual influence between the inverters. When one inverter is faulty, the other inverter cannot continue to be aged, and fault locating needs to be performed on both devices, which reduces production efficiency and increases labor costs for production and manufacturing.

### SUMMARY

This application provides an apparatus for testing an aging system module of a photovoltaic energy storage inverter, to resolve a problem of mutual influence between inverters in the conventional technology when an aging test is performed on an energy storage inverter by using a bidirectional analog source, or aging is performed in a two-machine parallel manner.

This application is implemented in this way. According to a first aspect, an apparatus for testing an aging system module of a photovoltaic energy storage inverter is provided, including at least one direct current power supply, a plurality of contactors, and an energy storage inverter. The energy storage inverter includes at least one boost module, a DC/DC module, and an inverter module. A PV end of each boost module is connected to an end of each direct current power supply, the other end of each boost module is connected to one end of the inverter module, a BAT end of the DC/DC module is connected in series to one contactor and is connected in parallel to at least one boost module, a GRID end and an EPS end of the other end of the inverter module are connected in series to different contactors respectively and are connected to one end of an alternating current power supply, and the other end of the alternating current power supply is connected to each direct current power supply.

Further, the contactor includes a first contactor, a second contactor, and a third contactor. The first contactor is connected between the PV end of the boost module and the BAT end of the DC/DC module, the second contactor is connected between the GRID end of the inverter module and the alternating current power supply, and the third contactor is connected between the EPS end of the inverter module and the alternating current power supply.

According to a second aspect, this application provides a test method for an apparatus for testing an aging system module of a photovoltaic energy storage inverter, including the following steps:
controlling, based on a test object, an on-off state of a contactor connected between a direct current power supply and an energy storage inverter and an on-off state of a contactor connected between the energy storage inverter and an alternating current power supply, and controlling, based on the test object, the direct current power supply to output a rated electrical signal; and
controlling, based on the on-off state of each contactor, a boost module and a DC/DC module to adjust a value of the output rated electrical signal, and outputting, based on different test objects through an output interface of an inverter module, the rated electrical signal to the alternating current power supply or performing an internal signal cycle test in the energy storage inverter.

Further, the controlling, based on a test object, an on-off state of a contactor connected between a direct current power supply and an energy storage inverter and an on-off state of a contactor connected between the energy storage inverter and an alternating current power supply, and controlling, based on the test object, each direct current power supply to output a rated electrical signal includes:
if the test object is an aging test for a grid-connected machine in the energy storage inverter, controlling a first contactor and a third contactor to be turned off, and a second contactor to be turned on, and controlling, based on a model parameter of the grid-connected machine in the energy storage inverter, any direct current power supply to output a rated current/voltage.

Further, the controlling, based on a test object, an on-off state of a contactor connected between a direct current power supply and an energy storage inverter and an on-off state of a contactor connected between the energy storage inverter and an alternating current power supply, and controlling, based on the test object, each direct current power supply to output a rated electrical signal further includes:
if the test object is an aging test for battery charge in the energy storage inverter, controlling a first contactor to be turned on, and a second contactor and a third contactor to be turned off, and controlling the direct current power supply connected to an end of the first contactor to output a rated current/voltage.

Further, the controlling, based on a test object, an on-off state of a contactor connected between a direct current power supply and an energy storage inverter and an on-off state of a contactor connected between the energy storage inverter and an alternating current power supply, and controlling, based on the test object, each direct current power supply to output a rated electrical signal further includes:
if the test object is an aging test for battery discharge in the energy storage inverter, controlling a first contactor and a third contactor to be turned on, a second contactor to be turned off, and the boost module connected to a BAT end to not operate, and simultaneously controlling the direct current power supply connected to the first contactor to output a rated current/voltage.

Further, the controlling, based on a test object, an on-off state of a contactor connected between a direct current power supply and an energy storage inverter and an on-off state of a contactor connected between the energy storage inverter and an alternating current power supply, and controlling, based on the test object, each direct current power supply to output a rated electrical signal further includes:
if the test object is an aging test for a multi-object combination in the energy storage inverter, starting all direct current power supplies that are connected to the boost module based on a PV end, controlling a first contactor to be turned on, and a second contactor or a third contactor to be turned on, and controlling each direct current power supply to output a rated current/voltage.

Further, the controlling, based on the on-off state of each contactor, a boost module and a DC/DC module to adjust a value of the output rated electrical signal, and outputting, based on different test objects through an output interface of an inverter module, the rated electrical signal to the alternating current power supply includes:
when the first contactor and the third contactor are turned off, and the second contactor is turned on, the DC/DC module does not participate in a control loop, and the rated voltage/current output by the direct current power supply is boosted by using the boost module connected in series and output to the inverter module, and is output to the alternating current power supply by using the second contactor connected to a GRID end of the inverter module.

Further, the controlling, based on the on-off state of each contactor, a boost module and a DC/DC module to adjust a value of the output rated electrical signal, and performing an internal signal cycle test in the energy storage inverter based on different test objects includes:
when the first contactor is turned on, and the second contactor and the third contactor are turned off, the rated current/voltage output by the direct current power supply connected to the first contactor is input, through a PV end, into the boost module that forms a loop with the DC/DC module for boosting, and then is bucked by using the DC/DC module, where a voltage at a BAT port connected to the first contactor is consistent with a voltage at a PV port, and there is a rated high current at the BAT port flowing to the PV end, to form an internal energy cycle.

Further, the controlling, based on the on-off state of each contactor, a boost module and a DC/DC module to adjust a value of the output rated electrical signal, and outputting, based on different test objects through an output interface of an inverter module, the rated electrical signal to the alternating current power supply further includes:
when the first contactor and the third contactor are turned on, the second contactor is turned off, and the boost module connected to the BAT end does not operate, the rated current/voltage output by the direct current power supply connected to the first contactor is input, through the first contactor, into the DC/DC module for boosting, and then is output to the alternating current power supply through an EPS end of the inverter module and the third contactor successively.

Beneficial effects achieved in this application are as follows: This application provides an apparatus for testing an aging system module of a photovoltaic energy storage inverter. A PV end of each boost module is connected to an end of each direct current power supply, the other end of each boost module is connected to one end of an inverter module, a BAT end of a DC/DC module is connected in series to one contactor and is connected in parallel to at least one boost module, a plurality of output interfaces of the other end of the inverter module are connected in series to different contactors respectively and are connected to one end of an alternating current power supply, and the other end of the alternating current power supply is connected to each direct current power supply. When battery charge/discharge of the energy storage inverter is performed and an aging test is performed on a grid-connected machine, the test can be implemented provided that on/off of a corresponding contactor is controlled, which has a more flexible combination, does not require a bidirectional analog source, and thus can reduce costs. In addition, an internal cycle between a BAT end and a PV end of a single energy storage inverter can be implemented provided that the on/off of the contactor is controlled, to complete a battery charge/discharge test, without a need for two or more parallel machines. In addition, an EPS end is connected to a power grid without an external load, which can reduce energy consumption.

### BRIEF DESCRIPTION OF THE DRAWINGS

To describe the technical solutions in the embodiments of this application or in the conventional technology more clearly, the following briefly describes the accompanying drawings required for describing the embodiments or the conventional technology. Clearly, the accompanying drawings in the following description show merely some embodiments of this application, and a person of ordinary skill in the art may still derive other accompanying drawings from these accompanying drawings without creative efforts.
FIG. 1 is a schematic circuit diagram of an apparatus for testing an aging system module of a photovoltaic energy storage inverter according to an embodiment of this application;
FIG. 2 is a flowchart of a test method for an apparatus for testing an aging system module of a photovoltaic energy storage inverter according to an embodiment of this application;
FIG. 3 is an operation diagram of a grid-connected machine test of a test method for an apparatus for testing an aging system module of a photovoltaic energy storage inverter according to an embodiment of this application;
FIG. 4 is an operation diagram of a battery charge test of a test method for an apparatus for testing an aging system module of a photovoltaic energy storage inverter according to an embodiment of this application;
FIG. 5 is an operation diagram of a battery discharge test of a test method for an apparatus for testing an aging system module of a photovoltaic energy storage inverter according to an embodiment of this application; and
FIG. 6 is a schematic operation diagram of a combined test of a test method for an apparatus for testing an aging system module of a photovoltaic energy storage inverter according to an embodiment of this application.

1: Direct current power supply; 2: Energy storage inverter; 3: Boost module; 4: DC/DC module; 5: Inverter module; 6: First contactor; 7: Second contactor; 8: Third contactor.

### DETAILED DESCRIPTION OF THE EMBODIMENTS

The following clearly and completely describes the technical solutions in embodiments of this application with reference to the accompanying drawings in the embodiments of this application. Clearly, the described embodiments are merely some rather than all of the embodiments of this application. All other embodiments obtained by a person of ordinary skill in the art based on the embodiments of this application without creative efforts shall fall within the protection scope of this application.

In this application, a PV end of each boost module is connected to an end of each direct current power supply, the other end of each boost module is connected to one end of an inverter module, a BAT end of a DC/DC module is connected in series to one contactor and is connected in parallel to at least one boost module, a plurality of output interfaces of the other end of the inverter module are connected in series to different contactors respectively and are connected to one end of an alternating current power supply, and the other end of the alternating current power supply is connected to each direct current power supply. When battery charge/discharge of the energy storage inverter is performed and an aging test is performed on a grid-connected machine, the test can be implemented provided that on/off of a corresponding contactor is controlled, which has a more flexible combination, does not require a bidirectional analog source, and thus can reduce costs. In addition, an internal cycle between a BAT end and a PV end of a single energy storage inverter can be implemented provided that the on/off of the contactor is controlled, to complete a battery charge/discharge test, without a need for two or more parallel machines. In addition, an EPS end is connected to a power grid without an external load, which can reduce energy consumption.

### Embodiment 1

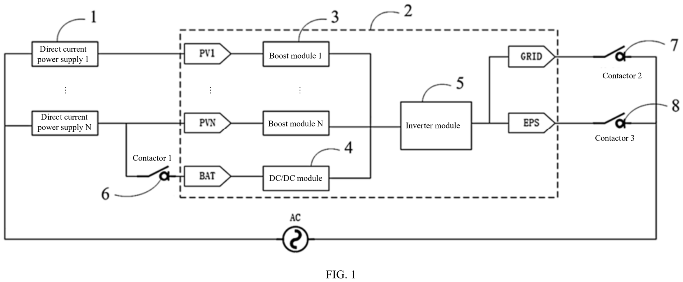

With reference to FIG. 1, an embodiment of this application provides an apparatus for testing an aging system module of a photovoltaic energy storage inverter, including at least one direct current power supply 1, a plurality of contactors, and an energy storage inverter 2. The energy storage inverter 2 includes at least one boost module 3, a DC/DC module 4, and an inverter module 5. A PV end of each boost module 3 is connected to an end of each direct current power supply 1, the other end of each boost module 3 is connected to one end of the inverter module 5, a BAT end of the DC/DC module 4 is connected in series to one contactor and is connected in parallel to at least one boost module 3, a GRID end and an EPS end of the other end of the inverter module 5 are connected in series to different contactors respectively and are connected to one end of an alternating current power supply, and the other end of the alternating current power supply is connected to each direct current power supply 1.

The direct current power supply 1 is configured to convert a voltage input by the alternating current power supply into a required rated direct current voltage or current. The contactor is configured to control on/off of a line during an aging test. The energy storage inverter 2 includes one DC/DC module 4 and N boost modules 3, and each boost module 3 includes one PV end. Each direct current power supply 1 is connected in a one-to-one correspondence to the PV end of the boost module 3 in the energy storage inverter 2, that is, a quantity of direct current power supplies 1 is consistent with a quantity of boost modules 3, and there are N direct current power supplies 1.

For ease of description, a contactor connected between the PV end of the boost module 3 and the BAT end of the DC/DC module 4 is used as a first contactor 6 (a contactor 1), a contactor connected between the GRID end of the inverter module 5 and the alternating current power supply is used as a second contactor 7 (a contactor 2), and a contactor connected between the EPS end of the inverter module 5 and the alternating current power supply is used as a third contactor 8 (a contactor 3). The BAT end of the DC/DC module 4 is connected in series to the first contactor 6 and then connected to the at least one PV end, and the other end of the DC/DC module 4 is connected to one end of the inverter module 5 together with each boost module 3. In this embodiment, a connection between the BAT end and a PV N end of the boost module N is used as an example for description.

More specifically, one end of each direct current power supply 1 is connected to the alternating current power supply AC at the same time, that is, is connected to a power grid at the same time, and the other end is connected in a one-to-one correspondence to the PV end of each boost module 3. The other end of each boost module 3 is connected to one end of the inverter module 5 at the same time. The other end of the inverter module 5 includes the GRID end and the EPS end. The GPID end is connected in series to the second contactor 7 and then connected to the power grid, and the EPS end is connected in series to the third contactor 8 and then returns to the power grid, to form an entire control loop.

More specifically, when an aging test for the energy storage inverter 2 is performed, based on the connection between the BAT end and the PV end, only the direct current power supply 1 that is jointly connected to the BAT end and the PV end needs to be used for power supply. The power supply may be controlled by using inverter software, and there is no need for a bidirectional analog power supply, so that charge/discharge aging of a BAT end of a single energy storage inverter 2 can be implemented.

More specifically, the first contactor 6 is connected between the PV end and the BAT end, the second contactor 7 is connected in series at the GRID end, and the third contactor 8 is connected in series at the EPS end. In the plurality of direct current power supplies 1, the direct current power supply 1 connected to the first contactor 6 is used for power supply, so that when an aging process of a grid-connected machine is simulated, simulation of the aging process of the grid-connected machine can be implemented provided that the second contactor 7 is controlled to be turned on, the first contactor 6 and the third contactor 8 are controlled to be turned off, and an output current or voltage of the direct current power supply 1 is controlled based on a model parameter of the grid-connected machine. When battery charge is simulated, the first contactor 6 is controlled to be turned on, the second contactor 7 and the third contactor 8 are controlled to be turned off, and a rated current/voltage output by the direct current power supply 1 connected to the first contactor 6 is cycled internally between the boost module 3 and the DC/DC module 4, thereby implementing simulation of a charge process. When battery discharge is simulated, the boost module 3 is controlled to not operate, the first contactor 6 is controlled to be turned on, and the rated current/voltage provided by the direct current power supply 1 successively passes through the DC/DC module 4 and the inverter module 5. When the second contactor 7 is turned on, the rated current/voltage is output through the GRID end of the inverter module 5, and when the third contactor 8 is turned on, the rated current/voltage is output through the EPS end of the inverter, thereby implementing simulation of a battery discharge process.

More specifically, alternatively, all of the direct current power supply 1 to the direct current power supply N may be started to operate. The first contactor 6 is turned on, either the second contactor 7 or the third contactor 8 is turned on, the DC/DC module 4 and the boost module 3N perform internal cycle operation, and power of another boost module 3 is fed back to the power grid by the inverter module 5 through the GRID end or the EPS end, thereby simultaneously implementing a plurality of test items. In addition, no external load is required in the process, which can reduce energy consumption during aging. In this manner, aging tests for a grid-connected relay, an off-grid relay, and a BYPASS relay inside the energy storage inverter can be implemented.

In the entire aging process, the energy storage inverter 2 communicates with an aging host computer in real time, and monitors related information such as voltages, currents, and power of the direct current power supply 1 and the energy storage inverter 2 during aging. In addition, the aging host computer can set passing and completion criteria for each stage of aging, so that a machine that does not meet the criteria and is faulty during aging is powered off in time, faults of the machine are recorded, aging of the machine is stopped, and aging of the machine is determined to be unqualified.

In this embodiment of this application, an apparatus for testing an aging system module of a photovoltaic energy storage inverter is provided. A PV end of each boost module 3 is connected to an end of each direct current power supply 1, the other end of each boost module 3 is connected to one end of an inverter module 5, a BAT end of a DC/DC module 4 is connected in series to one contactor and is connected in parallel to at least one boost module 3, a plurality of output interfaces of the other end of the inverter module 5 are connected in series to different contactors respectively and are connected to one end of an alternating current power supply, and the other end of the alternating current power supply is connected to each direct current power supply 1. When battery charge/discharge of the energy storage inverter 2 is performed and an aging test is performed on a grid-connected machine, the test can be implemented provided that on/off of a corresponding contactor is controlled, which has a more flexible combination, does not require a bidirectional analog source, and thus can reduce costs. In addition, an internal cycle between a BAT end and a PV end of a single energy storage inverter 2 can be implemented provided that the on/off of the contactor is controlled, to complete a battery charge/discharge test, without a need for two or more parallel machines. In addition, an EPS end is connected to a power grid without an external load, which can reduce energy consumption.

### Embodiment 2

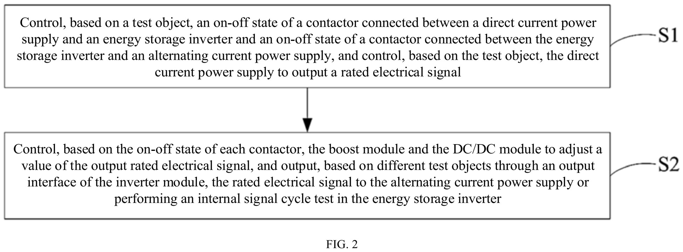

FIG. 2 is a flowchart of a test method for an apparatus for testing an aging system module of a photovoltaic energy storage inverter according to this embodiment. A test method for an apparatus for testing an aging system module of a photovoltaic energy storage inverter includes the following steps.

S1: Control, based on a test object, an on-off state of a contactor connected between a direct current power supply and an energy storage inverter and an on-off state of a contactor connected between the energy storage inverter and an alternating current power supply, and control, based on the test object, the direct current power supply to output a rated electrical signal.

S2: Control, based on the on-off state of each contactor, a boost module and a DC/DC module to adjust a value of the output rated electrical signal, and output, based on different test objects through an output interface of an inverter module, the rated electrical signal to the alternating current power supply or performing an internal signal cycle test in the energy storage inverter.

In this embodiment, a first contactor is connected between a BAT end of a DC/DC module and a PV end of a boost module, a second contactor is connected between a GRID end of an inverter module and a power grid, and a third contactor is connected between an EPS end of the inverter module and an alternating current power supply, so that aging tests are implemented, by controlling different contactors to be turned on or off, on different test objects based on a rated electrical signal provided by a direct current power supply.

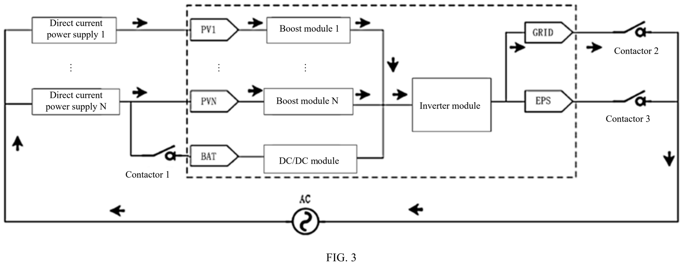

FIG. 3 is an optional embodiment based on Embodiment 2, specifically including the following step:
if the test object is an aging test for a grid-connected machine in the energy storage inverter, controlling a first contactor and a third contactor to be turned off, and a second contactor to be turned on, and controlling, based on a model parameter of the grid-connected machine in the energy storage inverter, any direct current power supply to output a rated current/voltage. In this case, the DC/DC module does not participate in a control loop, and the rated voltage/current output by the direct current power supply is boosted by using the voltage boost module connected in series and output to the inverter module, and is output to the power grid by using the second contactor connected to the GRID end of the inverter module, to form an analog control loop, thereby implementing simulation of an aging process of the grid-connected machine. As shown in FIG. 3, a power grid alternating current is converted into a direct current through a direct current power supply 1, and a corresponding voltage/current is output based on a model parameter of the grid-connected machine. The voltage/current passes through a PV 1 end, a boost module 1, an inverter module, a GRID end, and a second contactor successively, and finally is output to the power grid, to form the analog control loop, thereby implementing an aging simulation process of the grid-connected machine in the energy storage inverter. Alternatively, the second contactor may be turned off, the third contactor may be turned on, and the voltage/current may be output from the EPS end and the third contactor to the power grid.

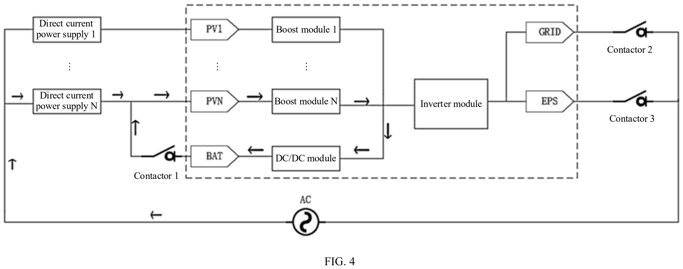

FIG. 4 is another optional embodiment based on Embodiment 2, specifically including the following step:
if the test object is an aging test for battery charge in the energy storage inverter, controlling a first contactor to be turned on, and a second contactor and a third contactor to be turned off, and controlling the direct current power supply connected to an end of the first contactor to output a rated current/voltage. In an aging process, the rated current/voltage output by the direct current power supply N connected to the first contactor is input, through the PV N end, into the boost module N that forms an analog control loop with the DC/DC module for boosting, to increase a bus voltage, and then is bucked by using the DC/DC module, so that a voltage at the BAT port connected to the first contactor is consistent with a voltage at the PV N end. Finally, the current/voltage is cycled internally between the boost module N and the DC/DC module to form a charge loop, thereby implementing the aging test process for battery charge. In the test process, the direct current power supply is controlled by internal software of the energy storage inverter, and only needs to supplement small loss of power to simulate a battery charge function of the energy storage inverter.

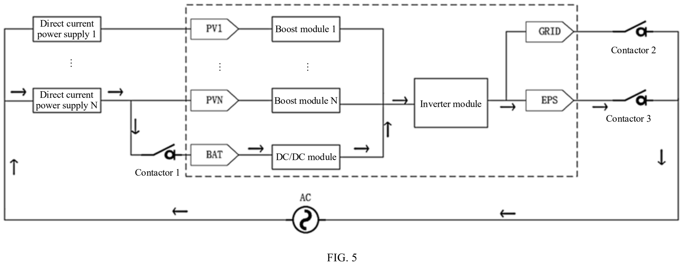

FIG. 5 is another optional embodiment based on Embodiment 2, specifically including the following step:
if the test object is an aging test for battery discharging in the energy storage inverter, controlling a first contactor and a third contactor to be turned on, and a second contactor to be turned off, controlling, by using software of the energy storage inverter, a boost module N connected to a BAT end to not operate, and controlling a direct current power supply N connected to the first contactor to output a rated current/voltage. The rated current/voltage output by the direct current power supply N is input to a DC/DC module through the first contactor for boosting, to increase a bus voltage, and simulate a discharge process. The increased bus voltage is discharged through the inverter module, an EPS end, and the third contactor successively, and finally returned to a power grid, to implement the aging test for battery discharge in the energy storage inverter. During the battery discharge test, alternatively, the second contactor may be turned on, the third contactor may be turned off, and discharge may be performed through the GRID end. This needs to be determined based on a specific aging solution.

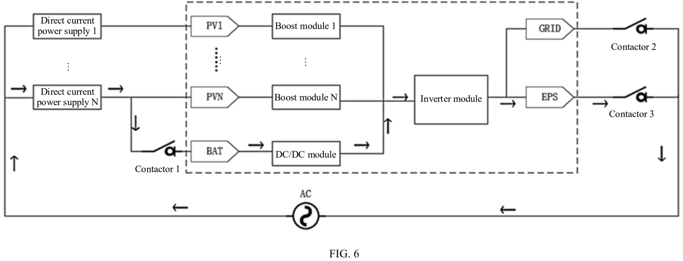

FIG. 6 is another optional embodiment based on Embodiment 2, specifically including the following step:
if the test object is an aging test for a multi-object combination in the energy storage inverter, starting all direct current power supplies that are connected to the boost module based on a PV end, controlling a first contactor to be turned on, and a second contactor or a third contactor to be turned on, and controlling each direct current power supply to output a rated current/voltage. In this aging process, the first contactor is turned on, and the second contactor or the third contactor is turned on, so that not only simulation of a battery charge process but also an aging test for a grid-connected machine can be implemented, so as to reduce aging test time, and improve test efficiency. More specifically, with reference to FIG. 6, a voltage/current output by a direct current power supply N passes through a PV N end, a voltage boost module N, a DC/DC module, a BAT end, and the first contactor, and then is returned to the PV N end, to form an internal cycle, so as to implement a battery charge simulation test. In addition, the voltage/current output by the direct current power supply 1 passes through a PV 1, a boost module 1, an inverter module, and a GRID end, and then is returned to a power grid through the second contactor to form a test loop, or flows through an EPS end from an inverter module, and then is returned to a power grid through the third contactor to form a test loop.

In this embodiment, all of the direct current power supply 1 to the direct current power supply N operate, the DC/DC module and the boost module N perform internal cycle operation, power of the boost module 1 to the boost module N-1 is fed back to the power grid by the inverter module through the GRID end or the EPS end, and no external load is required, which can reduce energy consumption during aging. External contactors of the GRID end and the EPS end use different turn-on schemes, and are adjusted by using internal software of the energy storage inverter, so as to implement aging tests for a grid-connected relay, an off-grid relay, or a BYPASS relay inside the energy storage inverter.

It should be noted that, according to the apparatus for testing an aging system module of a photovoltaic energy storage inverter provided in this application, a simple modification may be performed based on an existing grid-connected machine aging room, to meet a requirement for aging an energy storage machine. The modified aging device can be used to age the grid-connected machine or the energy storage machine. Both the machines can be aged at the same time without mutual interference.

As described above, in this embodiment of this application, a PV end of each boost module is connected to an end of each direct current power supply, the other end of each boost module is connected to one end of an inverter module, a BAT end of a DC/DC module is connected in series to one contactor and is connected in parallel to at least one boost module, a plurality of output interfaces of the other end of the inverter module are connected in series to different contactors respectively and are connected to one end of an alternating current power supply, and the other end of the alternating current power supply is connected to each direct current power supply. When battery charge/discharge of the energy storage inverter is performed and an aging test is performed on a grid-connected machine, the test can be implemented provided that on/off of a corresponding contactor is controlled, which has a more flexible combination, does not require a bidirectional analog source, and thus can reduce costs. In addition, an internal cycle between a BAT end and a PV end of a single energy storage inverter can be implemented provided that the on/off of the contactor is controlled, to complete a battery charge/discharge test, without a need for two or more parallel machines, which avoids mutual influence between the products. In addition, when a fault occurs, the machine can also be shut down independently without affecting aging of other products. In addition, an EPS end is connected to a power grid without an external load, which can reduce energy consumption.

It should be understood that the terms "first", "second", and the like in the specification, claims, or accompanying drawings of this application are used to distinguish between different objects, and are not used to describe a specific sequence. The "embodiment" mentioned in this specification means that a specific feature, structure, or characteristic described with reference to the embodiment may be included in at least one embodiment of this application. That the phrase appears at various positions in the specification does not necessarily refer to a same embodiment, nor is it a separate or alternative embodiment mutually exclusive with another embodiment. A person skilled in the art explicitly and implicitly understands that the embodiments described in the specification may be combined with another embodiment.

It should be understood that in this application, "a plurality of" means two or more. The term "and/or" is merely used to describe an association relationship between associated objects, and indicates that three relationships may exist. For example, A and/or B may indicate the following three cases: Only A exists, both A and B exist, and only B exists. The character "/" usually represents an "or" relationship between associated objects. "Including A, B, and C" means including all of A, B, and C, "including A, B, or C" means including one of A, B, and C, and "including A, B, and/or C" means including any one, two, or three of A, B, and C.

The foregoing disclosures are merely preferred embodiments of this application, and certainly are not intended to limit the scope of claims of this application. Therefore, equivalent changes made according to the claims of this application shall fall within the scope of this application.

## Claims

1. An apparatus for testing an aging system module of a photovoltaic energy storage inverter, **characterized by** comprising at least one direct current power supply, a plurality of contactors, and an energy storage inverter, wherein the energy storage inverter comprises at least one boost module, a DC/DC module, and an inverter module, a PV end of each boost module is connected to an end of each direct current power supply, the other end of each boost module is connected to one end of the inverter module, a BAT end of the DC/DC module is connected in series to one contactor and is connected in parallel to at least one boost module, a GRID end and an EPS end of the other end of the inverter module are connected in series to different contactors respectively and are connected to one end of an alternating current power supply, and the other end of the alternating current power supply is connected to each direct current power supply.

2. The apparatus for testing an aging system module of a photovoltaic energy storage inverter according to claim 1, **characterized in that** the contactor comprises a first contactor, a second contactor, and a third contactor, the first contactor is connected between the PV end of the boost module and the BAT end of the DC/DC module, the second contactor is connected between the GRID end of the inverter module and the alternating current power supply, and the third contactor is connected between the EPS end of the inverter module and the alternating current power supply.

3. A test method for an apparatus for testing an aging system module of a photovoltaic energy storage inverter, **characterized by** comprising the following steps:
controlling, based on a test object, an on-off state of a contactor connected between a direct current power supply and an energy storage inverter and an on-off state of a contactor connected between the energy storage inverter and an alternating current power supply, and controlling, based on the test object, the direct current power supply to output a rated electrical signal; and
controlling, based on the on-off state of each contactor, a boost module and a DC/DC module to adjust a value of the output rated electrical signal, and outputting, based on different test objects through an output interface of an inverter module, the rated electrical signal to the alternating current power supply or performing an internal signal cycle test in the energy storage inverter.

4. The test method for an apparatus for testing an aging system module of a photovoltaic energy storage inverter according to claim 3, **characterized in that** the controlling, based on a test object, an on-off state of a contactor connected between a direct current power supply and an energy storage inverter and an on-off state of a contactor connected between the energy storage inverter and an alternating current power supply, and controlling, based on the test object, each direct current power supply to output a rated electrical signal comprises:
if the test object is an aging test for a grid-connected machine in the energy storage inverter, controlling a first contactor and a third contactor to be turned off, and a second contactor to be turned on, and controlling, based on a model parameter of the grid-connected machine in the energy storage inverter, any direct current power supply to output a rated current/voltage.

5. The test method for an apparatus for testing an aging system module of a photovoltaic energy storage inverter according to claim 3, **characterized in that** the controlling, based on a test object, an on-off state of a contactor connected between a direct current power supply and an energy storage inverter and an on-off state of a contactor connected between the energy storage inverter and an alternating current power supply, and controlling, based on the test object, each direct current power supply to output a rated electrical signal further comprises:
if the test object is an aging test for battery charge in the energy storage inverter, controlling a first contactor to be turned on, and a second contactor and a third contactor to be turned off, and controlling the direct current power supply connected to an end of the first contactor to output a rated current/voltage.

6. The test method for an apparatus for testing an aging system module of a photovoltaic energy storage inverter according to claim 3, **characterized in that** the controlling, based on a test object, an on-off state of a contactor connected between a direct current power supply and an energy storage inverter and an on-off state of a contactor connected between the energy storage inverter and an alternating current power supply, and controlling, based on the test object, each direct current power supply to output a rated electrical signal further comprises:
if the test object is an aging test for battery discharge in the energy storage inverter, controlling a first contactor and a third contactor to be turned on, a second contactor to be turned off, and the boost module connected to a BAT end to not operate, and simultaneously controlling the direct current power supply connected to the first contactor to output a rated current/voltage.

7. The test method for an apparatus for testing an aging system module of a photovoltaic energy storage inverter according to claim 3, **characterized in that** the controlling, based on a test object, an on-off state of a contactor connected between a direct current power supply and an energy storage inverter and an on-off state of a contactor connected between the energy storage inverter and an alternating current power supply, and controlling, based on the test object, each direct current power supply to output a rated electrical signal further comprises:
if the test object is an aging test for a multi-object combination in the energy storage inverter, starting all direct current power supplies that are connected to the boost module based on a PV end, controlling a first contactor to be turned on, and a second contactor or a third contactor to be turned on, and controlling each direct current power supply to output a rated current/voltage.

8. The test method for an apparatus for testing an aging system module of a photovoltaic energy storage inverter according to claim 4, **characterized in that** the controlling, based on the on-off state of each contactor, a boost module and a DC/DC module to adjust a value of the output rated electrical signal, and outputting, based on different test objects through an output interface of an inverter module, the rated electrical signal to the alternating current power supply comprises:
when the first contactor and the third contactor are turned off, and the second contactor is turned on, the DC/DC module does not participate in a control loop, and the rated voltage/current output by the direct current power supply is boosted by using the boost module connected in series and output to the inverter module, and is output to the alternating current power supply by using the second contactor connected to a GRID end of the inverter module.

9. The test method for an apparatus for testing an aging system module of a photovoltaic energy storage inverter according to claim 5, **characterized in that** the controlling, based on the on-off state of each contactor, a boost module and a DC/DC module to adjust a value of the output rated electrical signal, and performing an internal signal cycle test in the energy storage inverter based on different test objects comprises:
when the first contactor is turned on, and the second contactor and the third contactor are turned off, the rated current/voltage output by the direct current power supply connected to the first contactor is input, through a PV end, into the boost module that forms a loop with the DC/DC module for boosting, and then is bucked by using the DC/DC module, wherein a voltage at a BAT port connected to the first contactor is consistent with a voltage at a PV port, and there is a rated high current at the BAT port flowing to the PV end, to form an internal energy cycle.

10. The test method for an apparatus for testing an aging system module of a photovoltaic energy storage inverter according to claim 6, **characterized in that** the controlling, based on the on-off state of each contactor, a boost module and a DC/DC module to adjust a value of the output rated electrical signal, and outputting, based on different test objects through an output interface of an inverter module, the rated electrical signal to the alternating current power supply further comprises:
when the first contactor and the third contactor are turned on, the second contactor is turned off, and the boost module connected to the BAT end does not operate, the rated current/voltage output by the direct current power supply connected to the first contactor is input, through the first contactor, into the DC/DC module for boosting, and then is output to the alternating current power supply through an EPS end of the inverter module and the third contactor successively.
